# EUROPÄISCHE PATENTSCHRIFT

(11) **EP 3 341 689 B1**
(45) Veröffentlichungstag und Bekanntmachung des Hinweises auf die Patenterteilung: **11.12.2019**
(21) Anmeldenummer: 16733060.4
(22) Anmeldetag: 27.06.2016
(51) Int. Cl.: G01D 5/20, G01R 27/26

(54) **VERFAHREN UND VORRICHTUNG ZUM BESTIMMEN EINER SENSORSPULENINDUKTIVITÄT**
METHOD AND DEVICE FOR DETERMINING THE INDUCTANCE OF A SENSOR COIL
MÉTHODE ET DISPOSITIF DE DÉTERMINATION DE L'INDUCTANCE D'UNE BOBINE DE CAPTEUR

(30) Priorität: 28.08.2015 DE 102015216479
(43) Veröffentlichungstag der Anmeldung: 04.07.2018
(73) Patentinhaber: Robert Bosch GmbH, 70442 Stuttgart (DE)
(72) Erfinder: BUCK, Thomas, 70839 Gerlingen-Schillerhoehe (DE); MERZ, Andreas, 71691 Freiberg Am Neckar (DE); LEIDICH, Stefan, 71277 Rutesheim (DE)
(86) Internationale Anmeldenummer: PCT/EP2016/064824
(87) Internationale Veröffentlichungsnummer: WO 2017/036626

(56) Entgegenhaltungen:
- EP-A2- 1 032 109
- DE-A1- 10 312 436
- DE-A1-102004 033 085
- DE-A1-102005 003 904

## Beschreibung

Die Erfindung betrifft ein Verfahren und eine Vorrichtung zum Bestimmen einer Sensorspuleninduktivität eines Wirbelstromsensors mittels einer LC-Oszillatorschaltung, wobei in Abhängigkeit einer Schwingfrequenz und einer Resonanzkapazität der LC-Oszillatorschaltung die Sensorspuleninduktivität durch Integration bestimmt wird.

### Stand der Technik

Verfahren und Vorrichtung der eingangs genannten Art sind aus dem Stand der Technik grundsätzlich bekannt. Zum Bestimmen einer Drehwinkelposition, beispielsweise eines Rotors einer elektrischen Maschine, sind unterschiedliche induktive Drehwinkelsensoren bekannt. Mehrheitlich wird die Kopplung zwischen einer Erregerspule und einer oder mehrerer Sensorspulen durch die Drehwinkellage eines Koppelelements, wie beispielsweise der Rotorwelle der elektrischen Maschine, beeinflusst. Eine entsprechende Lösung ist beispielsweise in der Offenlegungsschrift DE 197 388 36 A1 offenbart. Die Auswertung von Koppelfaktoren erfordert eine aufwändige Elektronik. Dabei wird das Spulensystem mit einem Hochfrequenzsignal angeregt, wodurch einfache Spiralspulen elektromagnetische Felder emittieren. Diese Emission ist zumindest im Nahfeld für das Funktionieren eines derartigen Sensors erforderlich. Im Fernfeld beziehungsweise Fernbereich wird das magnetische Feld jedoch nicht mehr für die Funktion benötigt. Jedoch kann das Feld im Fernbereich zu einer elektromagnetischen Unverträglichkeit in der Umgebung führen. Noch mehr als die Emission stellt die Einkopplung von Störsignalen ein Problem dar. In eine einfachen Spiralspule, welche einem magnetischen Wechselfeld ausgesetzt wird, wird eine Spannung induziert, welche mit der Sensorelektronik in eine nachteilige Wechselwirkung treten kann.

Um dieses Problem zu lösen ist es bereits aus der Offenlegungsschrift DE 10 2008 012 922 A1 bekannt, Schleifen mit unterschiedlichem Wicklungssinn in der Spule vorzusehen, sodass sich die magnetischen Felder im Fernbereich kompensieren und sich induzierte Spannungen neutralisieren.

Alternativ ist es bekannt, die Induktivität einer oder mehrerer Sensorspulen des Sensors bestimmt werden. Anhand der Induktivitäten einzelner Spulen lässt sich einfach auf den gemessenen Drehwinkel schließen. In der Regel erfolgt die Bestimmung einer Induktivität durch die Messung und Integrierung einer Schwingfrequenz einer LC-Oszillatorschaltung, wobei die Schwingfrequenz von der Induktivität abhängig ist. Entsprechend kann die erfasste Schwingfrequenz auch von einer von außen induzierten Spannung beeinflusst werden, sodass die Schwingfrequenz nicht mehr nur von der LC-Resonanzbedingung abhängig ist, sondern auch von der Frequenz des externen, die Spannung induzierenden Störsignals. Durch Aufteilen der Sensorspulen in zwei Teile und einer Invertierung des Wicklungssinns kann diese Einkopplung reduziert werden. Durch diese Maßnahme wird jedoch in der Regel auch die Induktivität reduziert, die jedoch maßgeblich die Spulengüte und somit die Frequenzstabilität bestimmt.

EP 0 368 128 A2 beschreibt eine weitere Oszillatorschaltung zur Induktivitätsmessung.

### Offenbarung der Erfindung

Das erfindungsgemäße Verfahren mit den Merkmalen des Anspruchs 1 hat den Vorteil, dass ohne aufwändige Anpassung des Sensorspulendesigns unter Berücksichtigung von elektromagnetischen Verträglichkeiten ein stabiler Betrieb des Wirbelstromsensors durch eine genaue Bestimmung der Sensorspuleninduktivität gewährleistet wird. Erfindungsgemäß ist hierzu vorgesehen, dass bei der Integration zur Bestimmung der Sensorspuleninduktivität die Schwingfrequenz wenigstens einmal verstimmt wird. Durch ein absichtliches Verstimmen der Schwingfrequenz wird erreicht, dass eine induzierte Spannung durch ein Störsignal beziehungsweise eine Störfrequenz nicht zu einem fehlerhaften Zählerstand der Integration führt.

Dadurch wird die Bestimmung der Spuleninduktivität durch das Störsignal nicht oder kaum beeinträchtigt.

Weiter ist vorgesehen, dass zum Verstimmen der Schwingfrequenz die Resonanzkapazität wenigstens einmal verändert wird. Durch das Beeinflussen und Verändern der Resonanzkapazität kann das Schwingverhalten der LC-Oszillatorschaltung auf einfache Weise beeinträchtigt werden, um die Schwingfrequenz zu verändern beziehungsweise zu verstimmen.

Insbesondere ist dabei vorgesehen, dass die Resonanzkapazität wenigstens einmal um einen vorgebbaren Wert erhöht wird. Dadurch wird die zu erfassende Schwingfrequenzfehlzeit der erhöhten Resonanzkapazität gezielt verringert und dadurch ein "Injection locking" durch die induzierte Fremdspannung beziehungsweise das Störsignal vermieden.

Im Weiteren ist vorgesehen, dass die Resonanzkapazität alternativ kontinuierlich erhöht wird. Hierzu wird bevorzugt der Resonanzkondensator der LC-Oszillatorschaltung während der Integration kontinuierlich moduliert, insbesondere entsprechend eines auf die Frequenz linear wirkenden Verlaufs. Auch hier ergeben sich die zuvor bereits genannten Vorteile. Der Zählerstand der Integration wird dann durch das Störsignal nicht oder kaum beeinflusst.

Besonders bevorzugt wird die Resonanzkapazität durch Hinzuschalten von wenigstens einem weiteren Kondensator erhöht. Insbesondere kann vorgesehen sein, dass ein Kondensatorarray beziehungsweise -feld in einem integrierten Schaltkreis mit einer Vielzahl gleicher und/oder unterschiedlicher Kondensatoren ausgebildet ist, die durch Halbleiterschalter mit der LC-Oszillatorschaltung, insbesondere mit dem Resonator beziehungsweise dem Resonanzkondensator, verbindbar und dadurch hinzuschaltbar sind. Das kontinuierliche oder quasi kontinuierliche Erhöhen der Resonanzkapazität, kann dabei ebenfalls durch eine Vielzahl von zuschaltbaren Einzelkapazitäten beziehungsweise Kondensatoren erreicht werden.

Gemäß einer bevorzugten Weiterbildung der Erfindung ist vorgesehen, dass zum Verstimmen der Schwingfrequenz alternativ oder zusätzlich eine Gatterlaufzeit eines digitalen Inverters des Oszillators der LC-Oszillatorschaltung verändert wird. Die Gatterlaufzeit (Gate-delay) beeinflusst ebenfalls die Schwingfrequenz der LC-Oszillatorschaltung. Durch das Verändern der Gatterlaufzeit kann eine Phasenverschiebung erreicht werden, welche die Schwingfrequenz verändert beziehungsweise verstimmt. Durch das Beeinflussen der Schwingfrequenz durch Verändern der Gatterlaufzeit kann auf zusätzlichen zuschaltbare Kondensatoren verzichtet und daher der Herstellungsaufwand reduziert werden. Vorzugsweise wird die Gatterlaufzeit durch Verwendung einer programmierbaren Stromquelle für die Einstellung von Bias-Strömen für Verstärkerstufen realisiert. Auch kann eine Kaskade von Verzögerungselementen in Reihe geschaltet werden, um die Schwingfrequenz zu verstimmen.

Gemäß einer bevorzugten Weiterbildung der Erfindung ist vorgesehen, dass die Resonanzkapazität in Abhängigkeit von einer erwarteten Störfrequenz erhöht wird. Dadurch kann das Verfahren beispielsweise für einen Einsatz in einer bestimmten Umgebung optimiert werden, in welcher zumindest ein Störsignal oder eine Störfrequenz durch eine elektrische/elektronische Einrichtung erwartet wird. Dadurch wird eine gezielte Verstimmung der Schwingfrequenz erreicht, die eine sichere Bestimmung der Spuleninduktivität gewährleistet.

Die erfindungsgemäße Vorrichtung mit den Merkmalen des Anspruchs 8 zeichnet sich durch ein speziell hergerichtetes Steuergerät aus, dass das erfindungsgemäße Verfahren bei bestimmungsgemäßen Gebrauch durchführt. Es ergeben sich hierdurch die genannten Vorteile. Weitere Vorteile und bevorzugte Merkmale ergeben sich aus dem zuvor Beschriebenen sowie aus den Ansprüchen.

Bevorzugt ist vorgesehen, dass die LC-Oszillatorschaltung wenigstens einen hinzuschaltbaren Kondensator zum Erhöhen der Resonanzkapazität beziehungsweise zum Beeinflussen/Verstimmen der Schwingfrequenz aufweist. Insbesondere sind mehrere Kondensatoren, wie zuvor bereits beschrieben, ausgebildet und beispielsweise durch Halbleiterschalter hinzuschaltbar.

Alternativ oder zusätzlich ist bevorzugt vorgesehen, dass der LC-Oszillatorschaltung einen Oszillator mit einem digitalen Inverter mit veränderlicher Gatterlaufzeit aufweist. Durch das Beeinflussen der Gatterlaufzeit wird - wie zuvor beschrieben - die Schwingfrequenz verstimmt und dadurch die Spuleninduktivität sicher bestimmt und eine sicherer und genauer Betrieb des Wirbelstromsensors insbesondere als Drehwinkelsensor gewährleistet.

Im Folgenden sollen die Erfindung und ihre Vorteile anhand von Ausführungsbeispielen näher erläutert werden. Dazu zeigen
- Figur 1: eine Vorrichtung zum Betreiben eines Wirbelstromsensors in einer vereinfachten Darstellung,
- Figuren 2A bis 2D: Schwingfrequenzen des Sensors ohne und mit Störsignal,
- Figuren 3A bis 3D: Schwingfrequenzen des Sensors bei Durchführung eines vorteilhaften Betriebsverfahrens und
- Figuren 4A bis 4D: Schwingfrequenzen des Sensors bei Durchführung eines alternativen Betriebsverfahrens.

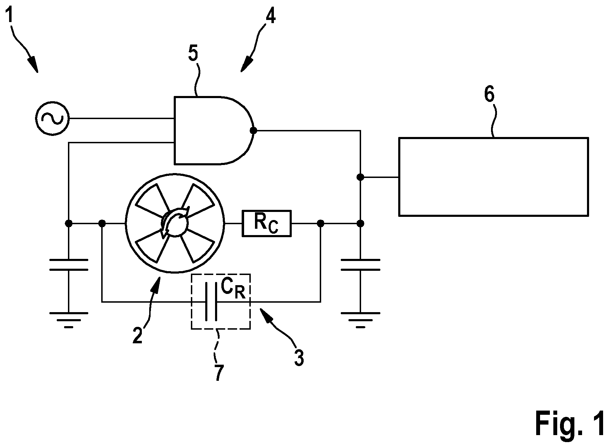

Figur 1 zeigt in der vereinfachten Darstellung eine Vorrichtung 1 zum Betreiben eines als Drehwinkelsensor eingesetzten Wirbelstromsensors 2, insbesondere zum Bestimmen einer Spuleninduktivität des Wirbelstromsensors 2. Die Vorrichtung 1 weist eine LC-Oszillatorschaltung 3 zur Erfassung der Spuleninduktiviät des Wirbelstromsensors 2 auf. Die Oszillatorschaltung 3 weist dazu die Induktivität L des Wirbelstromsensors 2 beziehungsweise dessen Sensorspulen, einen inneren Widerstand R_{C} des Wirbelstromsensors 2 sowie einen Resonanzkondensator C_{R} auf. Weiterhin weist die Schaltung 3 einen Oszillator 4 mit einem digitalen Inverter 5 auf. Ein Modul 6 berechnet aus der in der Schaltung 3 erzeugten Schwingfrequenz f einen durch den Wirbelstromsensor 2 erfassten Drehwinkel, beispielsweise des Rotors einer Elektromotors. Die Schaltung 3 schwingt dabei auf der LC-Resonanzfrequenz. Eine Digitalisierung und Bestimmung der Spuleninduktivität erfolgt erfindungsgemäß durch das Zählen der Perioden innerhalb einer Integrationszeit tᵢₙₜ.

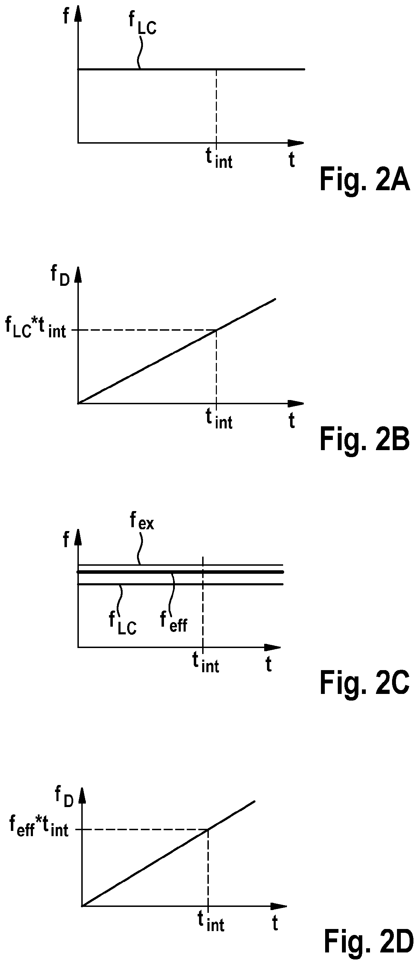

Figuren 2A und 2C zeigen den Verlauf der Schwingfrequenz f über die Integrationszeit tᵢₙₜ, wobei gemäß Figur 2A kein Störsignal vorliegt, und wobei Figur 2C den Fall zeigt, wenn ein Störsignal Sₑₓ vorliegt. Weiterhin zeigen die Figuren 2B und 2D die digitalisierte Frequenz f_{D}, die sich aus der Integration ergibt. Dabei wird angenommen, dass das Störsignal Sₑₓ ein CW-Signal ist und eine Störfrequenz fₑₛ aufweist, welche beispielsweise 100kHz von der LC-Resonanzfrequenz f_{LG} abweicht. Unter Annahme eines zeitlich konstanten Wertes der Resonanzkapazität des Kondensators C_{R} entspricht die Schwingfrequenz f entweder der LC-Resonanzfrequenz f_{LC}, wenn kein Störsignal Sₑₓ vorliegt, oder einer effektiven Frequenz f_{eff}, welche zwischen der LC-Resonanzfrequenz und der Frequenz des Störsignals Sₑₓ liegt. Es ist naheliegend, dass das Zählen der Perioden unter dem Einfluss des Störsignals Sₑₓ einen Zählerstand ergibt, der von der störungsfreien Situation abweicht. Durch das im folgenden beschriebene Verfahren, den vorteilhaften Betrieb und die vorteilhafte Beschaltung der Vorrichtung 1 wird erreicht, dass der Einfluss des Störsignals Sₑₓ nicht zu einem fehlerhaften Zählerstand (digitalisierte Frequenz f_{D}) führt und damit keinen oder zumindest einen verringerten Einfluss auf den mittels des Wirbelstromsensors 2 ermittelten Drehwinkels hat. Vorteilhafterweise weist die Schaltung 3 gemäß einem ersten Ausführungsbeispiel eine Vielzahl von Kondensatoren, insbesondere in Form eines Kondensatorarrays 7 auf, wie in Figur 1 angedeutet, die in einem integrierten Schaltkreis ausgebildet sind und durch Halbleiterschalter des Resonanzkreis beziehungsweise dem Resonator der Schaltung 3 verbindbar und zu dem Resonanzkondensator C_{R} hinzuschaltbar sind. Dazu werden beispielsweise Metall-Dielektrikum-Metall-Kapazitäten im Back-end-Prozess der Herstellung des integrierten Schaltkreises gefertigt. Zumindest ist wenigstens ein weiterer Kondensator zu der Schaltung 3 beziehungsweise zu dem Resonanzkondensator C_{R} hinzuschaltbar.

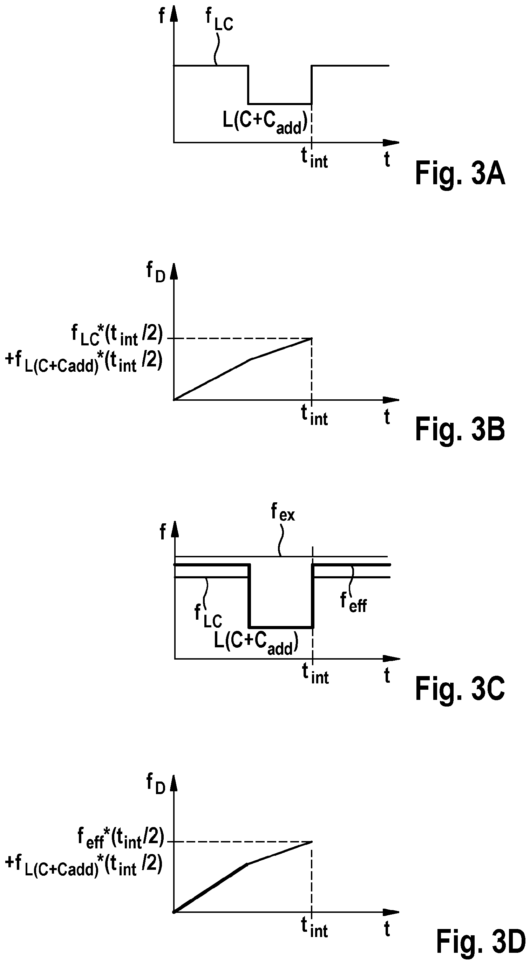

Ist nur ein weiterer Kondensator vorgesehen und hinzuschaltbar, so kann das in Figuren 3A bis 3D gezeigte Verfahren durchgeführt werden. Dabei ist vorgesehen, das während der Integration die Überprüfen der Sensorspule des Wirbelstromsensors 2 für die Häfte der Integrationszeit (tᵢₙₜ/2) mit dem Resonanzkondensator C_{R} beziehungsweise mit der dadurch gebildeten Resonanzkapazität abgeglichen wird. In der zweiten Hälfte der Integrationszeit wird die Sensorspule durch Hinzuschalten des weiteren Kondensators mit einer zusätzlichen Kapazität (C_{R}+C_{add}) abgeglichen. Die zusätzliche Kapazität C_{add} ist bevorzugt derart ausgewählt, dass sich die ursprüngliche Resonanzfrequenz um deutlich mehr als den Fangbereich des Injection Lockings verschiebt. Vorteilhafterweise werden die Kapazitäten wie folgt gewählt: C_{R}=68pF und C_{add}=5pF. Der Fangbereich des Injection Lockings liegt bei Planarspulen auf Leiterplatinenbasis mit einer Größe von ca. 5 mm typischerweise bei weniger als 100kHz. Durch das Hinzuschalten des weiteren Kondensators kann mindestens für die halbe Intergrationszeit die Beeinflussung durch das Störsignal Sₑₓ verhindert werden. Der Messfehler (Frequenzfehler) bei der Bestimmung der Spuleninduktivität kann somit halbiert werden. Weist die Schaltung 3 mehrere hinzuschaltbare Kondensatoren auf, ist es möglich, zusätzliche Stufen einzuführen und somit die Zeitspanne der möglichen Beeinflussung durch das Störsignal Sₑₓ weiter zu reduzieren.

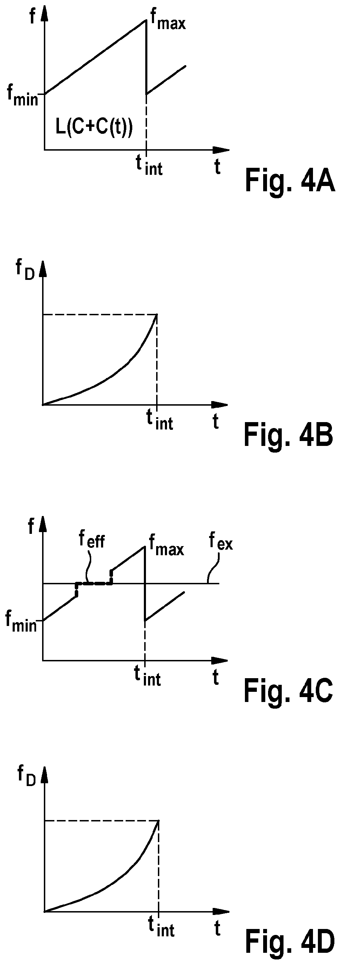

Figuren 4A bis 4D zeigen ein weiteres Ausführungsbeispiel, bei welchem die Schwingfrequenz f_{LC} kontinuierlich während der Integration moduliert wird, beispielsweise entsprechend eines auf die Frequenz linear wirkenden Verlaufs, wie in Figur 4A gezeigt. Im Fall der linearen Modulation und der Annahme, dass die Frequenz fₑₓ des Störsignals Sₑₓ zwischen fₘᵢₙ und fₘₐₓ liegt, wird der Zählerstand bei der Integration nicht das Störsignal Sₑₓ beeinflusst. Das Locken auf das Störsignal Sₑₓ verursacht eine Erhöhung der Schwingfrequenz f_{LC}, wenn die LC-Resonanzfrequenz f_{LC} niedriger als die Frequenz des Störsignals ist und der Frequenzabstand kleiner als der Fangbereich. Ebenso gibt es eine Phase in der die LC-Resonanzfrequenz f_{LC} höher als die Störfrequenz fₑₓ ist. Der Einfluss wird durch die Integration kompensiert und die Inaktivität der Sensorspule sehr genau bestimmt, sodass eine exakte Drehwinkelermittlung gewährleistet ist.

In dem Fall, dass die Störfrequenz fₑₓ des Störsignals Sₑₓ sehr nahe an fₘᵢₙ und fₘₐₓ liegt, kann dennoch eine Beeinflussung stattfinden, weil das Störsignal die LC-Resonanzfrequenz f_{LC} nur erhöht, beziehungsweise nur reduziert. In jedem Fall ist der Einfluss jedoch deutlich geringer als im Normalfall mit einem konstanten Wert des Resonanzkondensators C_{R}. In dem konkreten Beispiel kann der zu erwartende Winkelfehler von 0,5° auf 0,2° reduziert werden, wenn die Abgleichskapazität beziehungsweise die Kapazität des Resonanzkondensators zwischen 61,9 pF und 63,1 pF variiert wird. Eine Variation um 1 pF reduziert den Fehler auf 0,1° und bei einer Variation von 5 pF ist der Fehler nicht mehr messbar.

Der lineare oder quasi lineare Verlauf beziehungsweise die kontinuierliche Variation der Schwingfrequenz durch das Verändern des Resonanzkondensators kann durch die Vielzahl von Einzelkondensatoren, die hinzuschaltbar sind, wie zuvor beschrieben, erreicht werden. Vorteilhafterweise werden die Kondensatoren mit Kapazitätswerten entsprechend einem binären Muster ausgebildet, sodass die Kondensatorenkapazitäten von 0,1 pF; 0,2 pF; 0,4 pF; 0,8 pF; ... aufweisen. Durch eine gezielte Kombination können alle Werte zwischen 0 pF und dem zweifachen Maximalwert minus der Schrittweite in Schritten von 0,1 pF eingestellt werden. Die Verwendung von analogeinstellbaren Kapazitäten (Varaktoren) ist ebenso möglich, um die Schwingfrequenz der Schaltung 3 zu verstimmen.

Das Verstimmen der Schwingfrequenz während der Integration kann auch ohne die Veränderung der Abgleichskapazität erreicht werden. In dem vorliegenden Fall, in welchem die Schaltung durch einen Oszillator mit digitalen Inverter 5 realisiert ist, weist die dadurch vorhandene Gatterlaufzeit (Gate delayed) einen Einfluss auf die Schwingfrequenz auf. Eine Schwingung bleibt dann aufrecht erhalten, wenn das Signal am Ausgang des Inverters 5 mit einer Phasenverzögerung von -180° dem Eingang zugeführt wird. Der Resonanzkondensator C_{R} beziehungsweise der LC-Resonator weist bei der Resonanzfrequenz genau diese Phasenverschiebung auf. Eine Phasenverschiebung kann bei einer konkreten Schwingfrequenz in eine Zeitverzögerung umgerechnet werden. Im Falle von 25 Mhz beträgt die Periodendauer 40 ns. Eine Phasenverschiebung von -180° entspricht somit 20 ns. Die Gatterlaufzeit beträgt üblicherweise 1 bis 6 ns. Diese Verzögerungszeit wirkt reduzierend auf die geforderte Phasenverzögerung des Resonators. Konkret bedeutet dies, dass bei 2 ns (entspricht -18°) die Gatterlaufzeit und der Resonator nur noch eine Phasenverschiebung von -182° aufweisen müssen. Im Falle einer konkreten Belegung mit Werten für die Induktivität L und dem Resonanzkondensator C_{R} sinkt die Schwingfrequenz, da diese kleinere Phasenverschiebung bei einer niedrigeren Frequenz erreicht wird, weil der Phasengang des Pi- Resonators an der Resonanzfrequenz von 0° auf -180° wechselt. Die Steilheit hängt dabei von der Spulengüte ab. Die Gatterlaufzeit hat somit einen wohldefinierten Einfluss auf die Schwingfrequenz, sodass durch Beeinflussung der Gatterlaufzeit die Schwingfrequenz verstimmt werden kann, ohne dass dazu die Resonanzkapazität verändert werden muss. Das Beeinflussen der Gatterlaufzeit kann beispielsweise durch Verwendung einer programmierbaren Stromquelle für die Einstellung der Bias-Ströme von Verstärkerstufen praktisch realisiert werden. Des Weiteren können zusätzlich oder alternativ in einer integrierten Schaltung eine Kaskade von Verzögerungselementen in Reihe geschaltet werden.

Durch die vorteilhafte Vorrichtung und das beschriebene Verfahren ist es somit möglich, gezielt die Schwingfrequenz der Schaltung zu verstimmen, um ein Einlocken der Schwingfrequenz auf ein Störsignal zu verhindern. Dadurch können durch die Vorrichtung 1 auf einfache und kostengünstige Weise Anforderungen an eine elektromagnetische Verträglichkeit und eine Robustheit gegenüber Störsignalen erfüllt werden.

## Patentansprüche

1. Verfahren zum Bestimmen einer Sensor-Spuleninduktivität eines Wirbelstromsensors (2) mittels einer LC-Oszillatorschaltung (3), die die Induktivität (L) des Wirbelstromsensors (2), einen inneren Widerstand (R_{C}) des Wirbelstromsensors (2) sowie einen Resonanzkondensator (C_{R}) aufweist, wobei in Abhängigkeit von einer Schwingfrequenz (f_{LC}) und einer Resonanzkapazität der LC-Oszillatorschaltung (3) die Sensor-Spuleninduktivität bestimmt wird, wobei die Bestimmung der Spuleninduktivität durch das Zählen der Perioden innerhalb einer Integrationszeit erfolgt, **dadurch gekennzeichnet, dass** während der Integrationszeit die Schwingfrequenz (f_{LC}) wenigstens einmal verstimmt wird.

2. Verfahren nach Anspruch 1, **dadurch gekennzeichnet, dass** zum Verstimmen der Schwingfrequenz die Resonanzkapazität wenigstens einmal verändert wird.

3. Verfahren nach einem der vorhergehenden Ansprüche, **dadurch gekennzeichnet, dass** sie Resonanzkapazität wenigstens einmal um einen vorgebbaren Wert erhöht wird.

4. Verfahren nach einem der vorhergehenden Ansprüche, **dadurch gekennzeichnet, dass** die Resonanzkapazität kontinuierlich erhöht wird.

5. Verfahren nach einem der vorhergehenden Ansprüche, **dadurch gekennzeichnet, dass** die Resonanzkapazität durch Hinzuschalten von wenigstens einem weiteren Kondensator erhöht wird.

6. Verfahren nach einem der vorhergehenden Ansprüche, **dadurch gekennzeichnet, dass** zur Verstimmung eine Gatterlaufzeit eines digitalen Inverters (5) des Oszillators (4) verändert wird.

7. Verfahren nach einem der vorhergehenden Ansprüche, **dadurch gekennzeichnet, dass** die Resonanzkapazität in Abhängigkeit von einer erwarteten Störfrequenz (fₑₓ) erhöht wird.

8. Vorrichtung (1) zum Bestimmen einer Sensor-Spuleninduktivität eines Wirbelstromsensors (2), mit einer LC-Oszillatorschaltung (3), die wenigstens einen Resonanzkondensator (C_{R}), die Induktivität (L) des Wirbelstromsensors (2), einen inneren Widerstand (R_{C}) des Wirbelstromsensors (2) und eine Einrichtung zum Erfassen einer Schwingfrequenz (f_{LC}) der LC-Oszillatorschaltung (3) aufweist, **gekennzeichnet durch** ein speziell hergerichtetes Steuergerät, das bei bestimmungsgemäßen Gebrauch das Verfahren nach einem der Ansprüche 1 bis 7 durchführt.

9. Vorrichtung (1) nach Anspruch 8, **dadurch gekennzeichnet, dass** die LC-Oszillatorschaltung (3) wenigstens einen hinzuschaltbaren Kondensator zum Erhöhen der Resonanzkapazität aufweist.

10. Vorrichtung (1) nach Anspruch 8, **dadurch gekennzeichnet, dass** die LC-Oszillatorschaltung (3) einen Oszillator (4) mit einem Digitalinverter (5) und veränderbarer Gatterlaufzeit aufweist.

## Claims

1. Method for determining a sensor coil inductance of an eddy current sensor (2) by means of an LC oscillator circuit (3) which has the inductance (L) of the eddy current sensor (2), an internal resistance (R_{C}) of the eddy current sensor (2) and a resonance capacitor (C_{R}), wherein the sensor coil inductance is determined as a function of an oscillation frequency (f_{LC}) and a resonance capacitance of the LC oscillator circuit (3), wherein the determination of the coil inductance is carried out by counting the periods within an integration period, **characterized in that** during the integration period, the oscillation frequency (f_{LC}) is detuned at least once.

2. Method according to Claim 1, **characterized in that** for detuning the oscillation frequency, the resonance capacitance is changed at least once.

3. Method according to either of the preceding claims, **characterized in that** the resonance capacitance is increased at least once by a predefinable value.

4. Method according to one of the preceding claims, **characterized in that** the resonance capacitance is continuously increased.

5. Method according to one of the preceding claims, **characterized in that** the resonance capacitance is increased by additionally connecting at least one further capacitor.

6. Method according to one of the preceding claims, **characterized in that** for detuning, a gate delay of a digital inverter (5) of the oscillator (4) is changed.

7. Method according to one of the preceding claims, **characterized in that** the resonance capacitance is increased as a function of an expected interference frequency (fₑₓ).

8. Device (1) for determining a sensor coil inductance of an eddy current sensor (2), including an LC oscillator circuit (3) which has at least one resonance capacitor (C_{R}), the inductance (L) of the eddy current sensor (2), an internal resistance (R_{C}) of the eddy current sensor (2) and a device for detecting an oscillation frequency (f_{LC}) of the LC oscillator circuit (3), **characterized by** a specifically arranged control unit which carries out the method according to one of Claims 1 to 7, under normal use.

9. Device (1) according to Claim 8, **characterized in that** the LC oscillator circuit (3) has at least one additionally connectable capacitor for increasing the resonance capacitance.

10. Device (1) according to Claim 8, **characterized in that** the LC oscillator circuit (3) includes an oscillator (4) having a digital inverter (5) and a changeable gate delay.

## Revendications

1. Procédé de détermination de l'inductance d'une bobine de capteur d'un capteur à courants de Foucault (2) au moyen d'un circuit d'oscillateur LC (3), qui présente l'inductance (L) du capteur à courants de Foucault (2), une résistance interne (R_{C}) du capteur à courants de Foucault (2) ainsi qu'un condensateur de résonance (C_{R}), dans lequel on détermine l'inductance de la bobine de capteur en fonction d'une fréquence d'oscillation (f_{LC}) et d'une capacité de résonance du circuit d'oscillateur LC (3), dans lequel on effectue la détermination de l'inductance de la bobine par le comptage des périodes à l'intérieur d'un temps d'intégration, **caractérisé en ce que** l'on désaccorde au moins une fois la fréquence d'oscillation (f_{LC}) pendant le temps d'intégration.

2. Procédé selon la revendication 1, **caractérisé en ce que** l'on change au moins une fois la capacité de résonance pour désaccorder la fréquence d'oscillation.

3. Procédé selon l'une quelconque des revendications précédentes, **caractérisé en ce que** l'on augmente au moins une fois d'une valeur pouvant être prédéfinie la capacité de résonance.

4. Procédé selon l'une quelconque des revendications précédentes, **caractérisé en ce que** l'on augmente de façon continue la capacité de résonance.

5. Procédé selon l'une quelconque des revendications précédentes, **caractérisé en ce que** l'on augmente la capacité de résonance en connectant en plus au moins un autre condensateur.

6. Procédé selon l'une quelconque des revendications précédentes, **caractérisé en ce que** l'on change un temps de propagation de porte d'un inverseur numérique (5) de l'oscillateur (4) pour effectuer le désaccord.

7. Procédé selon l'une quelconque des revendications précédentes, **caractérisé en ce que** l'on augmente la capacité de résonance en fonction d'une fréquence perturbatrice attendue (fₑₓ).

8. Dispositif (1) de détermination de l'inductance d'une bobine de capteur d'un capteur à courants de Foucault (2), avec un circuit d'oscillateur LC (3), qui présente au moins un condensateur de résonance (C_{R}), l'inductance (L) du capteur à courants de Foucault (2), une résistance interne (R_{C}) du capteur à courants de Foucault (2) et un dispositif pour détecter une fréquence d'oscillation (f_{LC}) du circuit d'oscillateur LC (3), **caractérisé par** un appareil de commande spécifiquement reconfiguré, qui exécute en cas d'utilisation correcte le procédé selon l'une quelconque des revendications 1 à 7.

9. Dispositif (1) selon la revendication 8, **caractérisé en ce que** le circuit d'oscillateur LC (3) présente au moins un condensateur pouvant être connecté en plus pour augmenter la capacité de résonance.

10. Dispositif (1) selon la revendication 8, **caractérisé en ce que** le circuit d'oscillateur LC (3) présente un oscillateur (4) avec un inverseur numérique (5) et un temps de propagation de porte variable.
